(19)

**Europäisches Patentamt**
**European Patent Office**
**Office européen des brevets**

(11)  **EP 1 949 114 B1**

(12)  **EUROPÄISCHE PATENTSCHRIFT**

(45) Veröffentlichungstag und Bekanntmachung des Hinweises auf die Patenterteilung:
  **27.05.2009  Patentblatt 2009/22**

(21) Anmeldenummer: **06829914.8**

(22) Anmeldetag: **17.10.2006**

(51) Int Cl.:
  *G01R 19/00* (2006.01)    *H02P 6/00* (2006.01)

(86) Internationale Anmeldenummer:
  **PCT/EP2006/067484**

(87) Internationale Veröffentlichungsnummer:
  **WO 2007/045645 (26.04.2007 Gazette 2007/17)**

(54) **VERFAHREN ZUR MESSUNG EINES MOTORSTROMES**

  METHOD FOR MEASURING A MOTOR CURRENT

  PROCEDE POUR MESURER LE COURANT D'UN MOTEUR

(84) Benannte Vertragsstaaten:
  **AT BE BG CH CY CZ DE DK EE ES FI FR GB GR HU IE IS IT LI LT LU LV MC NL PL PT RO SE SI SK TR**

(30) Priorität: **18.10.2005  DE 102005050130**
    **09.10.2006  DE 102006047707**

(43) Veröffentlichungstag der Anmeldung:
  **30.07.2008  Patentblatt 2008/31**

(73) Patentinhaber: **SIEMENS AKTIENGESELLSCHAFT**
  **80333 München (DE)**

(72) Erfinder:
  • **KRAUSE, Uwe**
    **30982 Pattensen (DE)**
  • **LUDWIG, Heinz**
    **30823 Garbsen (DE)**
  • **NOLTE, Uwe**
    **30890 Barsinghausen (DE)**
  • **SONNTAG, Guido**
    **30989 Gehrden (DE)**

(56) Entgegenhaltungen:
  **US-A- 5 689 162**        **US-A- 5 930 103**

**Beschreibung**

Die Erfindung betrifft ein Verfahren zur Messung eines durch einen Motor fließenden Stromes, wobei ein den Motor mit elektrischer Energie versorgendes Leistungsschaltteil mittels einer Steuereinheit über ein Pulsweitenmodulations-Signal gesteuert wird, dass Pulsweitenmodulations-Signal einen Schaltzyklus aufweist, der Motorstrom bestimmt wird. US 5689162 und US 5930103 zeigen ein solches Verfahren.

Eine vorzugsweise vorzeichenbehaftete Messung des Motorstromes bei einer getakteten Anwendung, also beispielsweise einer Anwendung, bei der der Motor an einer H-Brücke betrieben wird, erfordert einen hohen Schaltungsaufwand, da beide Motoranschlüsse ständig getaktet werden, d.h. impulsartig mit Energie versorgt werden, und sich somit ein Potential gegenüber einer Auswerteelektronik verschiebt.

Eine H-Brücke ist in der Regel eine elektronische Schaltung, bestehend aus vier Schaltern, vorzugsweise ist sie mittels Transistoren bzw. Leistungshalbleitern aufgebaut. Die H-Brücke setzt eine Gleichspannung in eine Wechselspannung variabler Frequenz und variabler Pulsbreite um. Solch eine Schaltung wird vor allem zur Ansteuerung von Gleichstrommotoren und zur Wahl der Drehrichtung verwendet. Eine H-Brücke kann aber auch zum Speisen eines Transformators aus Gleichspannungsnetzen dienen. Des Weiteren findet eine H-Brücke beispielsweise in modernen Schaltnetzteilen Anwendung.

Auf Grund der Taktung ist der Motorstrom mit einem Wechselanteil versehen, dessen Höhe von einer Anschluss-Spannung, einem Tastverhältnis bzw. einem Impuls- und Pausenverhältnis eines Pulsweitenmodulations-Signals und einer wirksamen Induktivität des Motors abhängt. Die Messung eines zufälligen Momentanwertes des Motorstromes ist daher immer mit einer Unsicherheit des Wechselanteils versehen. Nach dem Stand der Technik werden zur Vermeidung eines Messfehlers, beispielsweise hervorgerufen durch so genannte Stromrippel, mehrere Messwerte erfasst und mittels einer Mittelwertbildung, beispielsweise durch einen Tiefpass mit einer Eckfrequenz, welche einen Bruchteil der Taktfrequenz entspricht, ermittelt. Der so ermittelte Messwert steht dann erst mit einer entsprechenden Zeitverzögerung zur Verfügung.

Aufgabe der Erfindung ist es, ein Verfahren zur Messung eines Motorstromes anzugeben, welches kostengünstiger und schneller den Motorstrom ermittelt als es beim Stand der Technik der Fall ist.

Diese Aufgabe wird durch die Merkmale des Anspruchs 1 gelöst.

In einer vorteilhaften Weiterbildung der Erfindung wird der Messwert in einer Zuleitung zum Leistungsschaltteil oder in einer Zuleitung zum Motor abgetastet. Eine sich auf ein Messergebnis ungünstig auswirkende Potentialverschiebung zwischen einer Auswerteelektronik und den Zuleitungen braucht nicht mehr berücksichtigt werden.

Nach einer weiteren Ausgestaltungsform wird als repräsentierender Messwert eine dem Motorstrom proportionale Größe abgetastet. Da der Motorstrom auch durch verschiedene, dem Motorstrom proportionale Größen dargestellt werden kann, ist es von Vorteil, dass der Motorstrom nicht direkt gemessen wird, sondern mittels eines indirekten Verfahrens bestimmt wird. Gegenüber einer direkten Motorstrommessung, insbesondere bei sehr hohen Strömen, kann durch die Ermittlung einer proportionalen Größe der Schaltungsaufbau und der messtechnische Aufwand gering gehalten werden. '

In einer vorteilhaften Ausgestaltungsform wird die dem Motorstrom proportionale Größe mittels eines Spannungsabfalls an einem Strommesswiderstand gebildet. Durch das beispielsweise Einbringen eines niederohmigen Messwiderstandes in eine Zuleitung des Leistungsschaltteils, wird durch eine Spannungsmessung an einem so genannten Shunt eine einfache und kostengünstige Messmethode bereitgestellt.

Zweckmäßig ist es hierbei, dass der Spannungsabfall innerhalb einer Spannungsmasche eine Eingangsspannung eines AD-Wandlers derart beeinflusst, dass durch eine Abweichung der Eingangsspannung zu einer Referenzspannung der Motorstrom bestimmt wird. Durch diese indirekte Strommessung mittels des Shunts kann eine leistungsarme Strommessung erfolgen.

In einer bevorzugten Ausführungsform wird ein Zeitpunkt der Abtastung durch ein Trigger-Signal der Steuereinheit bestimmt. Mittels des Trigger-Signals wird eine Synchronisation der Abtastung mittels des AD-Wandlers erreicht und auf die Zeit für eine Mittelwertbildung kann verzichtet werden. Durch das zusätzliche Trigger-Signal, welches aus dem Pulsweitenmodulations-Signal eines Pulsweiten-Modulators bestimmt wird, kann der Abtastzeitpunkt zuverlässig und reproduzierbar bestimmt werden.

Damit der Abtastzeitpunkt möglichst genau dem Zeitpunkt entspricht bei welchem der abgetastete Wert den Mittelwert des Motorstromes mit einer minimalen Abweichung wiedergibt, ist das Trigger-Signal derart veränderbar, dass der Zeitpunkt zur Kompensation von Lauf-Zeitfehlern zeitlich verschiebbar ist.

Da ein Schaltzyklus einen Impulsabschnitt mit einer Impulsweite und einen Pausenabschnitt mit einer Pausenweite aufweist, wird der Abtastzeitpunkt in die zeitliche Mitte eines der beiden Zyklusabschnitte gelegt. Hierbei wird berücksichtigt, dass der Stromrippel immer symmetrisch zum Mittelwert des Stromes liegt und in erster Näherung einen linearen Verlauf hat. Der kontinuierlich ansteigende Strom schneidet vorzugsweise genau in der Mitte eines Bestromungszyklusses den Mittelwert. Erfasst man also den Momentanwert des Stromes in der Mitte eines Bestromungszyklusses, so entspricht dieser Wert dem Mittelwert des zu erfassenden Stromes und es kann zusätzlich auf eventuelle Einschwingzeiten bei der Messung verzichtet werden.

Eine weitere Steigerung der Messgenauigkeit wird dadurch erreicht, dass der Abtastzeitpunkt in die zeitliche Mitte des längeren Zyklussabschnittes gelegt wird. Zur Erhöhung der Messgenauigkeit wird vorzugsweise die zeitliche Mitte einer jeweils längeren Bestromungsphase zur Abtastung verwendet. Beim Abtasten in der längeren Bestromungsphase wirken sich Umschaltstromspitzen aufgrund einer geringeren Stromanstiegsrate und ein möglicher zeitlicher Fehler der Triggerung bzw. Abtastung weniger aus.

Eine AnsteuerRichtung des Leistungsschaltteils wird zur Bestimmung einer Stromrichtung des Motorstromes berücksichtigt. Durch die zusätzliche Berücksichtigung der Ansteuerrichtung der H-Brücke wird der erfindungsgemäß ermittelte Motorstromwert entsprechend mit +1 oder -1 multipliziert und stimmt mit dem tatsächlichen Stromwert des Motors in Betrag und Vorzeichen überein.

Nachfolgend wird ein Ausführungsbeispiel der Erfindung anhand der Zeichnung näher erläutert. Hierin zeigen:

FIG 1     eine schematische Darstellung einer Motoransteuerung mit einer Messeinrichtung,

FIG 2     eine Übersicht der zeitlichen Verläufe von Ansteuersignalen und einer Spannung an einem Messwiderstand.

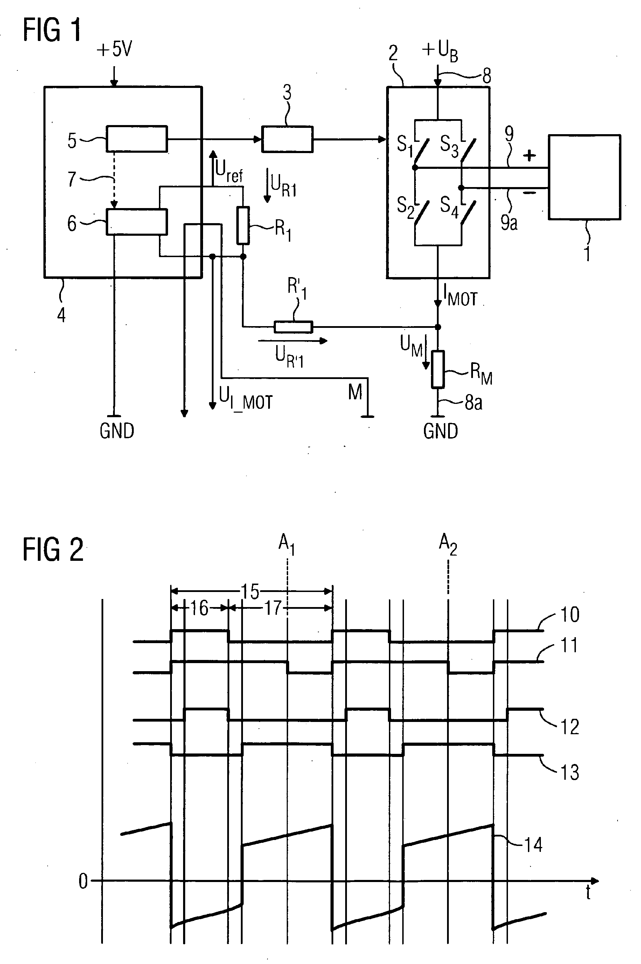

In FIG 1 ist ein Blockschaltbild einer Motoransteuerung für einen Motor 1 gezeigt. Der Motor 1 ist als ein Gleichstrommotor ausgelegt. Über ein Leistungsschaltteil 2 wird der Motor 1 mit elektrischer Energie über die Motorzuleitungen 9, 9a versorgt. Das Leistungsschaltteil 2 ist als eine H-Brücke ausgebildet. Eine Steuereinheit 4 stellt über einen Treiber 3 mehrere Ansteuersignale für das Leistungsschaltteil 2 bereit. Die Steuereinheit 4 weist einen Pulsweiten-Modulator 5 und einen Analog-Digital-Wandler 6, kurz AD-Wandler 6, auf, die durch einen frei konfigurierbaren Mikrocontrollers realisiert sind. Die Steuereinheit 4 wird mit einem +5 V Anschluss und einem Ground-Anschluss GND mit der notwendigen Versorgungsspannung versorgt. Neben den wesentlichen Elementen Pulsweiten-Modulator 5 und AD-Wandler 6 lassen sich in dem Mikrocontroller noch weitere Funktionen, etwa eine Protokollierung von Spitzenströmen oder ein Betriebsstundenzähler, implementieren bzw. realisieren.

Der Pulsweiten-Modulator 5 ist neben der Versorgung des Leistungsschaltteils 2 mit den Ansteuersignalen für die H-Brücke zusätzlich für die Bereitstellung eines Trigger-Signals für den AD-Wandler 6 ausgestaltet. Das Trigger-Signal wird über eine Triggerleitung 7 an den AD-Wandler 6 geführt. Das Trigger-Signal bestimmt den Zeitpunkt der Abtastung bzw. Messung.

Zur Messung einer Eingangsspannung $U_{I\_MOT}$ besitzt der AD-Wandler 6 drei Eingänge. Über einen ersten Eingang wird der AD-Wandler 6 im Wesentlichen mit einer Referenzspannung $U_{ref}$ versorgt. Über einen weiteren Eingang wird die Eingangsspannung $U_{I\_MOT}$ erfasst. Ein dritter Eingang verbindet den AD-Wandler 6 mit dem Ground-Anschluss GND.

Da in diesem Ausführungsbeispiel ein Motorstrom $I_{MOT}$ nicht direkt gemessen wird, ist in der Zuleitung 8a zum Leistungsschaltteil 2 ein Strommesswiderstand $R_M$ angeordnet. Das Leistungsschaltteil 2 wird über eine weitere Zuleitung 8 zum Leistungsschaltteil 2 mit einer Betriebsspannung $U_B$ versorgt. Parallel zum Strommesswiderstand $R_M$ ist ein Spannungsteiler mit Spannungsteilerwiderständen $R_1$ und $R_1$' angeordnet. Eine über dem Strommesswiderstand $R_M$ abfallende Spannung $U_M$ kann dadurch "abgegriffen" werden. Der Spannungsteilerwiderstand $R_1$ liegt dabei in einer Parallelschaltung zu den Eingängen für die Referenzspannung $U_{ref}$ und für die Eingangsspannung $U_{I\_MOT}$ des AD-Wandlers 6.

Die Spannungsversorgung des Leistungsschaltteils 2, also der H-Brücke, mit Gleichspannung erfolgt über die Zuleitungen 8,8a des Leistungsschaltteils 2. Die Zuleitung 8 versorgt das Leistungsschaltteil 2 mit der positiven Betriebsspannung $U_E$. Über die Zuleitung 8a zum Leistungsschaltteil 2 wird das Leistungsschaltteil 2 mit dem Bezugspotential GND verbunden. Der zu treibende Motor 1 befindet sich schaltungstechnisch in einem Mittelzweig zwischen einem linken und einem rechten Brückenzweig der H-Brücke. Im linken Brückenzweig sind ein erster Schalter S1 und ein zweiter Schalter S2 in einer Reihenschaltung angeordnet. Im rechten Brückenzweig sind ein dritter Schalter S3 und ein vierter Schalter S4 ebenfalls in Reihe angeordnet. Die beiden Brückenzweige bilden eine Parallelschaltung. Die vier Schalter S1 bis S4 sind vorzugsweise als Metal-Oxide-Semiconductor-Feldeffekttransistoren ausgestaltet. Solche Feldeffekttransistoren verfügen über Steuereingänge. Über diese Steuereingänge können die betreffenden Feldeffekttransistoren durch die Steuereinheit 4 mit den entsprechenden Ansteuersignalen ein- oder ausgeschaltet werden.

Durch die Steuereinheit 4 werden jeweils die sich diagonal gegenüberliegenden Schalter geschlossen, beispielsweise S2 und S3. Während die Schalter S2 und S3 geschlossen sind, bleiben die Schalter S1 und S4 geöffnet, da ansonsten ein direkter Kurzschluss der Versorgungsspannung $U_B$ die Folge wäre. Der Strom $I_{MOT}$ fließt in dieser Schaltstellung über die Zuleitung 8 zum Leistungsschaltteil 2 über den Schalter S3, über die Zuleitung 9a zum Motor 1, durch den Motor 1, über die Zuleitung 9 vom Motor 1, über den Schalter S2, über den Strommesswiderstand $R_M$ nach Ground GND. Damit stellt sich eine bestimmte Drehrichtung, sowie ein Drehmoment des Motors 1 ein. Werden die Schalter S2 und S3 geöffnet und danach die Schalter S1 und S4 geschlossen, fließt der Strom $I_{MOT}$ durch den Motor 1 in der entgegengesetzten Richtung. Damit wird der Motor in die entgegengesetzte Richtung angetrieben. Über eine Variation einer Impulsweite des Pulsweiten-Modulations-Signals erfolgt eine Leistungsregulierung bzw. eine Drehzahlsteuerung des Motors 1. -

Die bereits erwähnten Widerstände, Strommesswiderstand $R_M$, Spannungsteilerwiderstände $R_1$, $R_1$' und die Eingänge des AD-Wandlers 6 bilden eine Spannungsmasche M:

$$- U_{ref} + U_{R1} + U_{R1}' + U_M = O.$$

Im Folgenden werden zwei Fälle unterschieden:

In einem ersten Fall fließt kein Strom über die H-Brücke bzw. den Motor 1. Die Spannungsteilerwiderstände $R_1$ und $R_1$' sind jeweils zu 10 kΩ dimensioniert. Der Strommesswiderstand $R_M$ besitzt einen Widerstandwert von 1 Ω. Über dem Spannungsteilerwiderstand $R_1$' fällt demzufolge eine Spannung $U_{R1}$' ab. Bei einer Referenzspannung $U_{ref}$ = 5 V beträgt die am Spannungsteilerwiderstand $R_1$' abfallende Spannung $U_{R1}$' 2,5 V. Die Spannung $U_{R1}$' entspricht der Eingangsspannung $U_{I\_MOT}$ des AD-Wandlers 6. Der AD-Wandler 6 ist innerhalb des Mikrocontrollers der Steuereinheit 4 derart ausgestaltet, dass eine gemessene Eingangsspannung $U_{I\_MOT}$ = $U_{ref}/2$ einer Stromstärke $I_{MOT}$ von 0 A entspricht.

In einem zweiten Fall fließt über die H-Brücke bzw. über den Motor 1 ein Strom $I_{MOT}$. Der ansteigende Motorstrom $I_{MOT}$ ruft am Strommesswiderstand $R_M$ einen Spannungsabfall $U_M$ hervor. Durch diesen Spannungsabfall $U_M$ am Strommesswiderstand $R_M$ verändert sich der Spannungsabfall am Spannungsteilerwiderstand $R_1$. Demzufolge verändert sich auch der Spannungsabfall $U_{I\_MOT}$ am Messeingang des AD-Wandlers 6. Nimmt der Motor 1 Strom auf, steigt die Spannung $U_{I\_MOT}$ am AD-Wandler 6 proportional an. Speist der Motor 1 Strom zurück, sinkt die Spannung $U_{I\_MOT}$ am AD-Wandler 6 entsprechend. Zusätzlich kann der so ermittelte Wert durch eine Multiplikation mit +1 bzw. -1, abhängig von der jeweiligen Ansteuerrichtung der H-Brücke und Abtastung des Analogwertes in der Mitte eines Bestromungszyklusses direkt auf den vorzeichenbehafteten Mittelwert des Motorstromes $I_{MOT}$ umgerechnet werden. Die Abweichung von $U_{I-MOT}$ zu $U_{ref}/2$ ist der Spannung $U_M$ am Strommesswiderstand $R_M$ proportional, der Stromwert $I_{MOT}$ ist entsprechend proportional der Spannung $U_M$ und kann somit bestimmt werden.

FIG 2 zeigt die charakteristischen Verläufe der mittels des Pulsweiten-Modulators 5 aus FIG 1 erzeugten Ansteuersignale. Ein Pulsweitenmodulations-Signal 10, kurz PWM-Signal 10, zur Ansteuerung der H-Brücke weist einen Schaltzyklus 15 mit einer Impulsweite 16 und einer Pausenweite 17 auf. Aus dem PWM-Signal 10 des Pulsweiten-Modulators 5 wird ein Trigger-Signal 11 zur Bestimmung eines Abtastzeitpunktes $A_1$, $A_2$ abgeleitet. An der Stelle $A_1$ zeigt das Trigger-Signal 11 eine fallende Flanke, welche der Auslöser für den AD-Wandler 6 zur Abtastung der Eingangsspannung $U_{I-MOT}$ ist. Dieses Trigger-Signal 11 wird über die Triggerleitung 7 dem AD-Wandler 6 in FIG 1 zugeleitet. Des Weiteren ist ein Ansteuersignal 12 für die Schalter S2 und S3 und ein weiteres Ansteuersignal 13 für die Schalter S1 und S4 dargestellt. Die Ansteuersignale 12 und 13 weisen in einer zeitlichen Überlappung jeweils zu Begin und Ende der Impulsweite 16 bzw. der Pausenweite 17 eine anwendungsspezifische Totzeit auf. Diese Totzeit dient der Vermeidung, dass die Schalter S1 bis S4 gleichzeitig geschlossen sind. Bei einem Spannungszwischenkreis ist die Totzeit, wie dargestellt, "positiv", hingegen bei einem Stromzwischenkreis wird eine "negative" Totzeit verwendet, d.h. es wird bewusst eine Überlappung, bei der beide Signale ein positives Ansteuerpotential aufweisen, eingestellt.

Betrachtet man das Abbild des Motorstromes $I_{MOT}$, welches durch den Spannungsverlauf 14 am Strommesswiderstand $R_M$ während einer Pausenweite 17 gegeben ist, so erfolgt die Abtastung des Motorstromwertes $I_{MOT}$ bzw. der Eingangsspannung $U_{I-MOT}$ des AD-Wandlers 6 in der zeitlichen Mitte A1 der Pausenweite 17. Der kontinuierliche Anstieg des Motorstromes $I_{MOT}$ bzw. des Spannungsverlauf 14 während einer Pausenweite 17 entspricht einem linearen Anstieg, welcher symmetrisch zur zeitlichen Mitte der Pausenweite 17 ist. Der so ermittelte Momentanwert entspricht in guter Nährung dem Mittelwert des Motorstromes $I_{MOT}$.

**Patentansprüche**

**1.** Verfahren zur Messung eines durch einen Motor (1) fliesenden Stromes ($I_{MOT}$), wobei ein den Motor (1) mit elektrischer Energie versorgendes Leistungsschaltteil (2) mittels einer Steuereinheit (4) über ein Pulsweitenmodulations-Signal (10) gesteuert wird, das einen Schaltzyklus (15) mit einem Impulsabschnitt mit einer Impulsweite (16) und einen Pausenabschnitt mit einer Pausenweite (17) aufweist, wobei zur Bestimmung des Motorstromes ($I_{MOT}$) pro Schaltzyklus (15) genau ein den Motorstrom ($I_{MOT}$) repräsentierender Messwert abgetastet wird, dessen Abtastzeitpunkt ($A_1$, $A_2$) durch ein Trigger-Signal (11) der Steuereinheit (4) bestimmt wird,
**dadurch gekennzeichnet, dass**
das Trigger-Signal (11) der Steuereinheit derart veränderbar ist, dass zur Kompensation von Laufzeitfehlern der Abtastzeitpunkt ($A_1$, $A_2$) anwenderspezifisch frei wählbar in die zeitliche Mitte eines der beiden, vorzugsweise in den längeren, Zyklusabschnitte (16,17) gelegt wird und dass zur Bestimmung der Stromrichtung des Motorstromes

($I_{MOT}$) die Ansteuer-Richtung des Leistungsschaltteils (2) berücksichtigt wird, indem der ermittelte Motorstromwert ($I_{MOT}$) durch Multiplikation mit +1 bzw. -1, abhängig von der jeweiligen Ansteuerrichtung des Leistungsschaltteils (2)und Abtastung des Analogwertes in der zeitlichen Mitte des gewählten Zyklusabschnitts direkt auf den vorzeichenbehafteten Mittelwert des Motorstromes ($I_{MOT}$) umgerechnet wird.

**2.** Verfahren nach Anspruch 1,
**dadurch gekennzeichnet, dass**
der den Motorstrom ($I_{MOT}$) repräsentierender Messwert in einer Zuleitung (8, 8a) zum Leistungsschaltteil (2) oder in einer Zuleitung (9, 9a) zum Motor (1) abgetastet wird.

**3.** Verfahren nach Anspruch 2,
**dadurch gekennzeichnet, dass**
als repräsentierender Messwert eine dem Motorstrom ($I_{MOT}$) proportionale Größe ($U_M$) abgetastet wird.

**4.** Verfahren nach Anspruch 3,
**dadurch gekennzeichnet, dass**
die dem Motorstrom ($I_{MOT}$) proportionale Größe ($U_M$) mittels eines Spannungsabfalls ($U_M$) an einem Strommesswiderstand ($R_M$) gebildet wird.

**5.** Verfahren nach Anspruch 4,
wobei der Spannungsabfall ($U_M$) innerhalb einer Spannungsmasche (M) eine Eingangsspannung ($U_{I-MOT}$) eines AD-Wandlers (6) derart beeinflusst, dass durch eine Abweichung zu einer Referenzspannung ($U_{ref}$) der Motorstrom ($I_{MOT}$) bestimmt wird.

**Claims**

**1.** Method for measuring a current ($I_{MOT}$) flowing through a motor (1), wherein a power switching section (2), which supplies the motor (1) with electrical power, is controlled by means of a control unit (4) via a pulse-width modulation signal (10), which has a switching cycle (15) having a pulse section with a pulse width (16), and has a pause section with a pause width (17), wherein, in order to determine the motor current ($I_{MOT}$), one and only one measured value which represents the motor current ($I_{MOT}$) is sampled in each switching cycle (15), whose sampling time ($A_1$, $A_2$) is defined by a trigger signal (11) from the control unit (4)
**characterized in that**
the trigger signal (11) from the control unit can be varied such that the sampling time ($A_1$, $A_2$) is placed, such that it can be varied freely on a user-specific basis, in the center of the time of one of the two cycle sections (16, 17), preferably in the longer cycle section (16, 17), in order to compensate for delay time errors, and **in that**, in order to determine the current direction of the motor current ($I_{MOT}$), the drive direction of the power switching section (2) is taken into account **in that** the determined motor current value ($I_{MOT}$) is converted directly, by multiplication by +1 or -1, depending on the respective drive direction of the power switching section (2), and the sampling of the analog value in the center of the time of the chosen cycle section, to the signed mean value of the motor current ($I_{MOT}$) .

**2.** Method according to Claim 1,
**characterized in that**
the measured value which represents the motor current ($I_{MOT}$) is sampled in a supply line (8, 8a) to the power switching section (2) or in a supply line (9, 9a) to the motor (1).

**3.** Method according to Claim 2,
**characterized in that**
a variable ($U_M$) which is proportional to the motor current ($I_{MOT}$) is sampled as a representative measured value.

**4.** Method according to Claim 3,
**characterized in that**
the variable ($U_M$) which is proportional to the motor current ($I_{MOT}$) is formed by means of a voltage drop ($U_M$) across a current measurement resistor ($R_M$).

**5.** Method according to Claim 4,
wherein the voltage drop ($U_M$) within a voltage mesh (M) influences an input voltage ($U_{I\,MOT}$) of an A/D converter (6) such that the motor current ($I_{MOT}$) is determined by any discrepancy from a reference voltage ($U_{ref}$).

**Revendications**

1. Procédé de mesure d'un courant ( $I_{MOT}$ ) passant dans un moteur ( 1 ), dans lequel une partie ( 2 ) d'interruption de puissance alimentant le moteur ( 1 ) en énergie électrique est commandée au moyen d'une unité ( 4 ) de commande par un signal ( 10 ) de modulation en largeur d'impulsion, qui a un cycle ( 15 ;) de commutation comprenant une partie d'impulsion ayant une largeur ( 16 ) d'impulsion et une partie de repos ayant une largeur ( 17 ) de repos, dans lequel, pour la détermination du courant ( $I_{MOT}$ ) du moteur, on échantillonne par cycle ( 15 ) de commutation exactement une valeur de mesure représentant le courant ( $I_{MOT}$ ) du moteur, dont l'instant ( $A_1$, $A_2$ ) d'échantillonnage est déterminé par un signal ( 11 ) de déclenchement de l'unité ( 4 ) de commande,
**caractérisé en ce que**
le signal ( 11 ) de déclenchement de l'unité de commande peut être modifié de façon à ce que pour la compensation d'erreur de temps de propagation, l'instant ( $A_1$, $A_2$ ) d'étalonnage peut être choisi librement et spécifiquement à l'utilisateur dans le milieu temporel de l'une des deux parties ( 16, 17 ) du cycle, de préférence dans la plus longue et **en ce que**, pour la détermination du sens du courant ( $I_{MOT}$ ) du moteur, on tient compte du sens de commande de la partie ( 2 ) d'interruption de puissance en transformant par le calcul le courant ( $I_{MOT}$ ) déterminé du courant du moteur par multiplication par +1 ou par -1, en fonction du sens de commande respectif de la partie ( 2 ) d'interruption de puissance et par échantillonnage de la valeur analogique dans le milieu temporel de la partie du cycle choisie, directement en la valeur moyenne, munie d'un signe, du courant ( $I_{MOT}$ ) du moteur.

2. Procédé suivant la revendication 1,
**caractérisé en ce que**
l'on échantillonne la valeur de mesure représentant le courant ( $I_{MOT}$ ) du moteur dans une ligne ( 8, 8a ) d'entrée menant à la partie ( 2 ) d'interruption de puissance ou dans une ligne ( 9, 9a ) d'entrée menant au moteur ( 1 ) .

3. Procédé suivant la revendication 2,
**caractérisé en ce que**
l'on échantillonne comme valeur de mesure représentative une grandeur ( $U_M$ ) proportionnelle au courant ( $I_{MOT}$ ) du moteur.

4. Procédé suivant la revendication 3,
**caractérisé en ce que**
l'on forme sur une résistance ( $R_M$ ) de mesure du courant la grandeur ( $U_M$ ) proportionnelle au courant ( $I_{MOT}$ ) du moteur au moyen d'une chute ( $U_M$ ) de tension.

5. Procédé suivant la revendication 4,
dans lequel la chute ( $U_M$ ) de tension influence au sein d'une maille ( M ) de tension, une tension ( $U_{I\_MOT}$ ) d'entrée d'un convertisseur ( 6 ) AD, de façon à déterminer le courant ( $I_{MOT}$ ) du moteur par un écart à une tension ( $U_{ref}$ ) .

## FIG 1

## FIG 2

**EP 1 949 114 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5689162 A
- US 5930103 A